# EUROPEAN PATENT SPECIFICATION

(11) **EP 4 276 969 B1**
(45) Date of publication and mention of the grant of the patent: **25.11.2026**
(21) Application number: 22859570.8
(22) Date of filing: 02.08.2022
(51) Int. Cl.: H01M 10/42, G01R 31/36, H01M 10/48, H01M 10/44

(54) **CELL VOLTAGE ESTIMATION METHOD AND BATTERY SYSTEM PROVIDING SAME**
VERFAHREN ZUR SCHÄTZUNG DER ZELLENSPANNUNG UND BATTERIESYSTEM DAMIT
PROCÉDÉ D'ESTIMATION DE TENSION D'ÉLÉMENT ET SYSTÈME DE BATTERIE LE METTANT EN OEUVRE

(30) Priority: 01.12.2021 KR 20210169966
(43) Date of publication of application: 15.11.2023
(73) Proprietor: LG Energy Solution, Ltd., Seoul 07335 (KR)
(72) Inventor: KIM, Kwang Min, Daejeon 34122 (KR)
(74) Representative: Goddar, Heinz J.
(86) International application number: PCT/KR2022/011343
(87) International publication number: WO 2023/101136

(56) References cited:
- JP-A- 2004 028 861
- JP-A- 2009 059 504
- KR-A- 20130 129 508
- KR-A- 20160 059 193
- US-A1- 2017 054 134
- US-A1- 2021 123 980
- US-A1- 2021 199 724
- US-B2- 8 583 389

## Description

### TECHNICAL FIELD

The present disclosure relates to a cell voltage estimation method for estimating a cell voltage of each of a plurality of battery cells connected in parallel and to a battery system providing the method.

### BACKGROUND

As a usage period of a battery including a plurality of battery cells increases, a deviation (a voltage, SOC, etc.) between the battery cells may increase. If the cell-to-cell deviation increases, the battery may be over-discharged and/or overcharged. If the overcharge/over-discharge is repeated, the aging of the battery accelerates, and various problems such as an increase in the possibility of causing a fire may occur. To solve this, a battery management system (BMS) calculates the cell deviation at a predetermined cycle, and performs cell balancing when the cell deviation exceeds a reference value.

When a plurality of battery cells are connected in series, a monitoring IC is electrically connected to each of a plurality of battery cells to measure the cell voltage, and transmits the measurement result to the MCU. The MCU may calculate the voltage deviation or the SOC deviation between a plurality of battery cells based on the cell voltage, and control the monitoring IC to perform the cell balancing.

On the other hand, when a plurality of battery cells are connected in parallel, there is a limit in that the cell voltage cannot be directly measured due to a problem such as a narrow space or a cost according to the characteristic of the in parallel connection. In addition, in the case of in parallel connection, the cell balancing was not performed in many cases in the existing battery system in anticipation of a self-balancing effect between a plurality of battery cells.

However, even between a plurality of battery cells connected in parallel, the resistance of each battery cell may vary due to various causes. As a result, a cell voltage difference may occur due to the difference in the amount of the current applied to each battery cell, and the deviation between the cells may increase according to the cell voltage difference.

For example, when each of a plurality of battery modules connected in series includes a plurality of battery cells connected in parallel, it is difficult to directly measure the cell voltage value of each of a plurality of battery cells connected in parallel. Accordingly, the BMS determines whether to perform module balancing based on the module voltage value, which is the voltage (a terminal voltage) value at both terminals of the battery module that may be directly measured. In this case, the cell voltage value of each of a plurality of battery cells included in each battery module may not be considered, so that the over-discharge and/or the overcharge of some battery cells may occur. Patent applications US 2021/199724 A1 and US 2021/123980 A1 disclose respective battery systems involving equivalent circuit models for whole batteries.

The background description provided herein is for the purpose of generally presenting context of the disclosure. Unless otherwise indicated herein, the materials described in this section are not prior art to the claims in this application and are not admitted to be prior art, or suggestions of the prior art, by inclusion in this section.

### SUMMARY

The present disclosure provides a cell voltage estimation method capable of estimating the cell voltage of each of a plurality of battery cells even when a plurality of battery cells are connected in parallel, and a battery system providing the method.

A battery system of the present disclosure includes: a battery including a plurality of battery modules connected in series, each of the plurality of battery modules comprising a plurality of battery cells connected in parallel; a temperature sensor measuring a cell temperature of each of the plurality of battery cells; and a BMS (battery management system) determining an estimated cell resistance value corresponding to a measured cell temperature value by using a first look-up table for each of the plurality of battery cells, determining an estimated cell current value based on the estimated cell resistance value and an estimated cell voltage value estimated during an (N-1)-th estimation period, N being a natural number greater than or equal to 1, determining an estimated cell capacity (SOC, State of Charge) corresponding to the estimated cell current value by using a capacity estimation model, and determining the estimated cell voltage value corresponding to the estimated cell capacity as the estimated cell voltage value during an N-th estimation period using a second look-up table.

The first look-up table may include the estimated cell resistance value corresponding to a predetermined cell temperature value, the capacity estimation model may determine the cell capacity corresponding to a predetermined cell current value, and the second look-up table may include a cell voltage (OCV, Open Circuit Voltage) value corresponding to a predetermined cell capacity.

The BMS determines whether to perform a module balancing between each of the plurality of battery modules connected in series based on the estimated cell voltage value for each of the plurality of battery cells.

The BMS determines a module voltage value of each of the plurality of battery modules based on a minimum cell voltage value among a plurality of cell voltage values of the plurality of battery cells included in each of the plurality of battery modules and determine whether to perform the module balancing based on the module voltage value.

The first look-up table may include the estimated cell resistance value corresponding to a predetermined cell temperature value, the capacity estimation model may determine the estimated cell capacity corresponding to a predetermined cell current value, and the second look-up table may include a cell voltage (OCV, Open Circuit Voltage) value corresponding to a predetermined cell capacity.

A method for determining an estimated cell voltage value for each of a plurality of battery cells in a battery system, the battery system including a plurality of battery modules connected in series and the plurality of battery cells connected in parallel for each of a plurality of battery modules, the method includes: receiving a measured cell temperature value of each of the plurality of battery cells; determining an estimated cell resistance value corresponding to the measured cell temperature value by using a first look-up table; determining an estimated cell current value based on an estimated cell resistance value and an estimated cell voltage value during an (N-1)-th estimation period; determining an estimated cell capacity (SOC, State of Charge) corresponding to the estimated cell current value by using a capacity estimation model; and determining the estimated cell voltage value corresponding to the estimated cell capacity using a second look-up table during an N-th estimation period.

The method for estimating the cell voltage value further includes, after determining the estimated cell voltage value, determining whether to perform a module balancing between the plurality of battery modules based on the estimated cell voltage value for each of the plurality of battery cells.

Whether to perform the module balancing is determined based on a minimum cell voltage value, a module voltage of each of the plurality of battery modules is determined based on a minimum cell voltage value among a plurality of cell voltage values of the plurality of battery cells included in each of the plurality of battery modules, and whether to perform the module balancing is determined based on the module voltage value.

The method for estimating the cell voltage value may further include, upon determining performing of the module balancing is required, performing the module balancing based on a lowest module voltage value among module voltage values of the plurality of battery modules.

The first look-up table may include a cell resistance value corresponding to a predetermined cell temperature value, the capacity estimation model may determine the estimated cell capacity corresponding to a predetermined cell current value, and the second look-up table may include a cell voltage (OCV, Open Circuit Voltage) value corresponding to the predetermined cell capacity.

The estimated cell capacity may correspond to a State of Charge (SOC).

The cell voltage value may correspond to an Open Circuit Voltage (OCV).

In the present disclosure, even when a plurality of battery cells are connected in parallel, the cell voltage of each of a plurality of battery cells may be estimated.

In the present disclosure, when each of a plurality of battery modules connected in series includes a plurality of battery cells connected in parallel, some battery cells may be prevented from being over-discharged and/or overcharged by controlling the module balancing based on the estimated cell voltage value.

The effects of the present disclosure are not limited to the effects mentioned above and additional other effects not described above will be clearly understood from the description of the appended claims by those skilled in the art.

### BRIEF DESCRIPTION OF THE DRAWINGS

The accompanying drawings, which are incorporated in and constitute a part of this specification, illustrate various exemplary embodiments and together with the description, serve to explain the principles of the disclosed embodiments.
FIG. 1 is a view illustrating a battery system including a plurality of battery cells connected in parallel according to an embodiment.
FIG. 2 is an example diagram for explaining a method of estimating a cell voltage of each of two battery cells connected in parallel according to an embodiment.
FIG. 3 is a view illustrating a battery system in which a plurality of battery modules including a plurality of battery cells connected in parallel are connected in series according to another embodiment.
FIG. 4 is a flowchart explaining a cell voltage estimation method according to another embodiment.

### DETAILED DESCRIPTION

Hereinafter, an embodiment disclosed the present specification will be described in detail with reference to the accompanying drawings, and the same or similar constituent factors are denoted by the same reference numerals regardless of a reference numeral, and a repeated description thereof will be omitted. Suffixes "module" and/or "unit" for a constituent factor used for the description below are given or mixed in consideration of only easiness of the writing of the specification, and the suffix itself does not have a discriminated meaning or role. Further, in describing the embodiment disclosed in the present disclosure, when it is determined that detailed description relating to well-known functions or configurations may make the subject matter of the embodiment disclosed in the present disclosure unnecessarily ambiguous, the detailed description will be omitted. Further, the accompanying drawings are provided for helping to easily understand embodiments disclosed in the present specification, and the technical spirit disclosed in the present specification is not limited by the accompanying drawings, and it will be appreciated that the present disclosure includes all of modifications, equivalent matters, and substitutes included in the spirit and the technical scope of the present disclosure.

Terms including an ordinal number, such as first and second, are used for describing various constituent factors, but the constituent factors are not limited by the terms. The terms are used only to discriminate one constituent factor from another constituent factor.

It should be understood that when one constituent factor is referred to as being "coupled to" or "connected to" another constituent factor, one constituent factor can be directly coupled to or connected to the other constituent factor, but intervening factors may also be present. By contrast, when one constituent factor is referred to as being "directly coupled to" or "directly connected to" another constituent factor, it should be understood that there are no intervening factors.

In the present application, it will be appreciated that terms "including" and "having" are intended to designate the existence of characteristics, numbers, steps, operations, constituent factors, and components described in the specification or a combination thereof, and do not exclude a possibility of the existence or addition of one or more other characteristics, numbers, steps, operations, constituent factors, and components, or a combination thereof in advance.

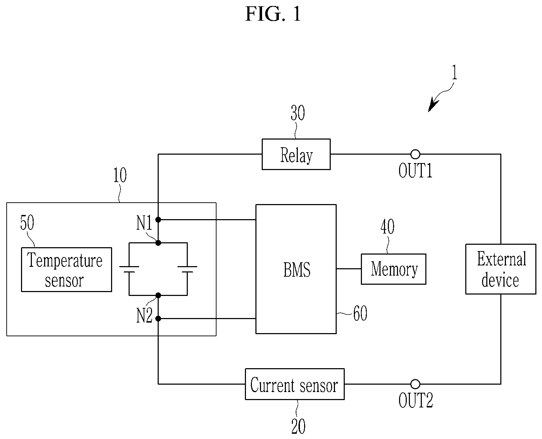

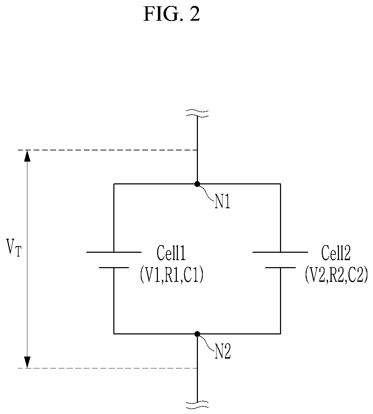

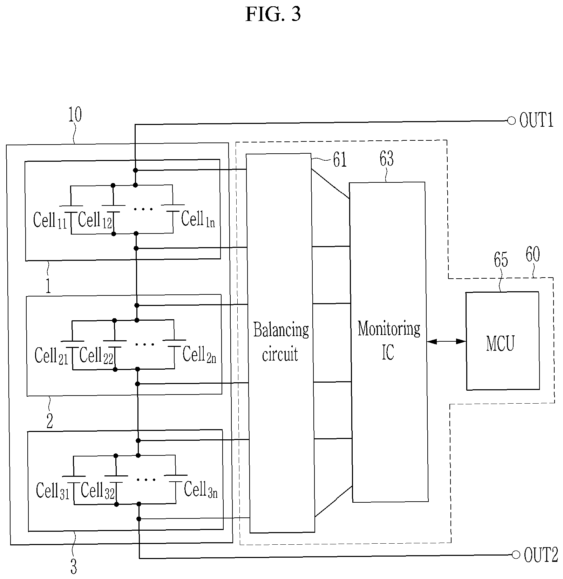

FIG. 1 is a view illustrating a battery system including a plurality of battery cells connected in parallel according to an embodiment, FIG. 2 is an example diagram for explaining a method of estimating a cell voltage of each of two battery cells connected in parallel according to an embodiment, and FIG. 3 is a view illustrating a battery system in which a plurality of battery modules including a plurality of battery cells connected in parallel are connected in series according to another embodiment.

Referring to FIG. 1, a battery system 1 includes a battery 10, a current sensor 20, a relay 30, a memory 40, a temperature sensor 50, and a battery management system (hereinafter referred to as 'BMS') 60.

The battery 10 may include a plurality of battery cells Cell₁ to Cellₙ electrically connected in parallel. In some embodiments, the battery cell may be a rechargeable battery that is rechargeable. Also, referring to FIG. 3, the battery 10 may be configured such that a plurality of battery modules 1, 2, and 3 including a plurality of battery cells Cell₁ to Cellₙ that are electrically connected in parallel are connected in series. However, the present disclosure is not limited thereto, and the battery 10 may be configured such that a plurality of battery modules 1, 2, and 3 including a plurality of battery cells Cell₁ to Cellₙ are connected in series/in parallel.

Both terminals of the battery 10 may be electrically connected to the BMS 60. The BMS 60 can measure the voltage (hereinafter, a terminal voltage) across both ends of the battery 10. Alternatively, a voltage sensor (not shown) may measure the terminal voltage (Voltage Terminal, V_{T}) and transmit the measurement result to the BMS 60. Referring to FIG. 3, both terminals of each of a plurality of battery modules 1-3 may be electrically connected to the BMS 60. The BMS 60 may measure a voltage across both terminals (hereinafter, a terminal voltage) of each of a plurality of battery modules 1-3.

The terminal voltage V_{T} may be a voltage between the positive and negative electrodes of a plurality of battery cells connected in parallel. When a sufficient time elapses to perform self-balancing of a plurality of battery cells, the terminal voltage (V_{T}) value and the cell voltage value of a plurality of battery cells Cell₁ to Cellₙ may be the same. Therefore, for example, the terminal voltage VT in FIG. 1 may be the voltage across both terminals of the battery 10. Also, the terminal voltage V_{T} in FIG. 3 may be a module voltage that is the voltage across both terminals of a battery module (j) including a plurality of battery cells Cell₁ to Cellₙ connected in parallel. Therefore, in each of the first battery module 1, the second battery module 2, and the third battery module 3, which are connected in series in FIG. 3, the terminal voltage V_{T} value may be different.

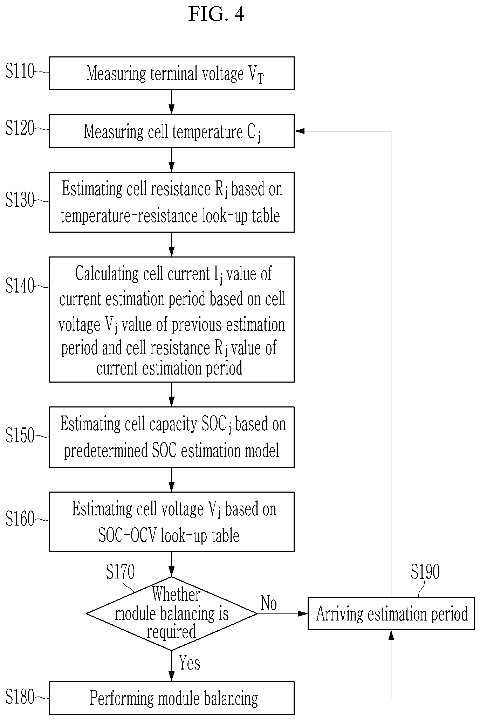

Unlike as shown in FIG. 1, when a plurality of battery cells Cell₁ to Cellₙ are connected in parallel, it is difficult to directly measure the cell voltage of each of a plurality of battery cells Cell₁ to Cellₙ due to the structural characteristics. In the battery system 1 according to an embodiment, the cell voltage value of each of a plurality of battery cells Cell₁ to Cellₙ may be estimated according to the method described in FIG. 4.

In FIG. 1, the battery 10 is connected between two output terminals OUT1 and OUT2 of the battery system 1, the relay 30 is connected between the positive electrode of the battery system 1 and the first output terminal OUT1, and the current sensor 20 is connected between the negative electrode of the battery system 1 and the second output terminal OUT2. The components shown in FIG. 1 and a connection relationship between the components are an example and the present disclosure but are not limited thereto.

The current sensor 20 is connected in series to the current path between the battery 10 and an external device. The current sensor 20 may measure the terminal current I flowing through the battery 10, that is, the charging current and the discharge current, and transmit the measurement result to the BMS 60. According to an embodiment, the current value measured by the current sensor 20 may correspond to the summed current value of the cell currents I₁ to Iₙ flowing in each of a plurality of battery cells Cell₁ to Cellₙ connected in parallel.

The relay 30 controls the electrical connection between the battery system 1 and an external device. When the relay 30 is turned on, the battery system 1 and the external device are electrically connected to perform the charge or the discharge, and when the relay 30 is turned off, the battery system 1 and the external device are electrically disconnected. In this case, the external device may be a charger in a charging cycle in which the battery 10 is charged by supplying the power, and may be a load in a discharge cycle in which the battery 10 discharges the power to the external device.

The memory 40 may store a first look-up table including a cell resistance value corresponding to a predetermined cell temperature value, a capacity estimation model for estimating a cell capacity (SOC, State of Charge) based on the cell current value, and a second look-up table including the cell voltage value corresponding to the predetermined capacity (SOC).

The first look-up table may be stored by mapping a cell resistance value corresponding to a predetermined cell temperature value experimentally obtained for a predetermined battery cell model. That is, the first look-up table may be a look-up table based on a temperature-resistance correlation. The capacity estimation model may be a model for estimating the cell capacity (SOC) by various other conventionally known methods, such as based on a method such as a current integration method (Coulomb Counting, Ampere Counting). The second look-up table may be a table in which a state of charge (SOC) value and an open circuit voltage (OCV) value are matched.

The temperature sensor 50 may measure a cell temperature (C₁-Cₙ) of each of a plurality of battery cells Cell₁ to Cellₙ and transmit the measurement result to the BMS 60. In FIG. 1, only one temperature sensor 50 is displayed, but the present disclosure is not limited thereto, and the cell temperature (C₁-Cₙ) of each of a plurality of battery cells Cell₁ to Cellₙ may be measured in various numbers and shapes.

The BMS 60 may measure the terminal voltage V_{T}. Hereinafter, it is described that the BMS 60 measures the terminal voltage V_{T}, but this is not limited thereto, and a voltage sensor (not shown) may include measuring the terminal voltage V_{T}.

Referring to FIG. 3, the BMS 60 may include a balancing circuit 61, a monitoring IC 63, and an MCU 65.

The balancing circuit 61 may reduce a voltage deviation (or a SOC deviation) between the battery modules 1 to 3 by performing the module balancing between the battery modules 1 to 3.

The monitoring IC 63 may measure a module voltage of each of a plurality of battery modules 1 to 3 for each predetermined estimation period T, and transmit the measurement result to the MCU 65. According to an embodiment, the module voltage of each of a plurality of battery modules 1 to 3 may be the terminal voltage V_{T} necessary for estimating the cell voltage of a plurality of battery cells included in each of a plurality of battery modules 1 to 3.

The MCU 65 may estimate the cell voltage V₁-Vₙ value of each of a plurality of battery cells connected in parallel based on the terminal voltage V_{T} and the cell temperature C measured for each predetermined estimation period T.

Referring to FIG. 3, for example, the MCU 65 estimates the cell voltage V₁-Vₙ value of each of a plurality of battery cells Cell₁ to Cellₙ included in each of a plurality of battery modules 1 to 3 for each predetermined estimation period Tj. The MCU 65 determines the necessity of the module balancing for a plurality of battery modules 1 to 3 based on the estimated cell voltage (V₁-Vₙ) value. After that, if the module balancing is necessary as the determination result, the MCU 65 may control the balancing circuit 61 to control the module balancing between battery modules 1 to 3. The more detailed description is described in FIG. 4 below.

FIG. 2 is an example diagram for explaining a method of estimating a cell voltage of each of two battery cells connected in parallel according to an embodiment.

FIG. 2 shows two battery cells, but the present disclosure is not limited thereto, and the cell voltage of each of two or more battery cells may be estimated by the method described below.

Referring to FIG. 1 and FIG. 2, the BMS 60 receives the first temperature T1_{N} and the second temperature T2_{N}, which are the respective cell temperatures of the first battery cell Cell₁ and the second battery cell Cell₂ for each predetermined estimation period T₁, ..., T_{N-1}, and T_{N} from the temperature sensor 50. The following description is described based on a predetermined estimation period T_{N}.

The temperature sensor 50 may measure the cell temperature of each of the first battery cell Cell₁ and the second battery cell Cell₂ per the predetermined estimation period T₁, ... , T_{N-1}, T_{N} and may transmit the measurement result to the BMS 60.

Next, the BMS 60 estimates a first resistance R1_{N} and a second resistance R2_{N} respectively corresponding to each of a first temperature T1_{N} and a second temperature T2_{N} based on the first look-up table in which the temperature-resistance relationship stored in memory 40 is recorded. In this case, the first resistance R1_{N} and the second resistance R2_{N} may correspond to the cell resistances of the first battery cell Cell₁ and the second battery cell Cell₂, respectively.

Next, the BMS 60 calculates the cell current value of each of the first battery cell Cell₁ and the second battery cell Cell₂ from the current estimation period T_{N} based on the cell voltage value of the previous estimation period T_{N-1} and the cell resistance value of the current estimation period T_{N}.

The current and the voltage are closely related to the passage of time. That is, the current value at a predetermined estimation time (e.g., an N time) is closely related to the voltage value of the previous estimation time N-1. From this point of view, if the concept of the time is added to Ohm's law, it may be as shown in Equations 1 and 2 below. ${V 1}_{N - 1} = {I 1}_{N} \times {R 1}_{N}$ (Equation 1) ${V 2}_{N - 1} = {I 2}_{N} \times {R 2}_{N}$ (Equation 2)

According to an embodiment, the BMS 60 may calculate the first current I1 value and the second current I2 value in the current estimation period T_{N} for the first battery cell Cell₁ and the second battery cell Cell₂, respectively, based on Equations 1 and 2.

In Equation 1, it shows that the first current I1_{N} value, which is the cell current of the first battery cell Cell₁, may be calculated in the current estimation period T_{N} by applying the first voltage V1_{N-1} value of the previous estimation period T_{N-1} and the first resistance R1_{N} value of the current estimation period T_{N} to Ohm's law.

In Equation 2, it shows that the second current I2_{N} value, which is the cell current of the second battery cell Cell₂, may be calculated in the current estimation period T_{N} by applying the value of the second voltage V2_{N-1} of the previous estimation period T_{N-1} and the value of the second resistance R2_{N} of the current estimation period T_{N} to Ohm's law.

In Equations 1 and 2, the first voltage V1_{N-1} value and the second voltage V2_{N-1} value of the last estimation time N-1 may be pre-estimated and stored in the memory 40. Also, the first resistance R1_{N} value and the second resistance R2_{N} value of the current estimation period T_{N} may be pre-estimated and stored in the memory 40.

In a 0th estimation period T₀, it is assumed that the battery cells are in an initial state in which the battery cells are not used, or a plurality of battery cells Cell₁ to Cellₙ sufficiently perform the self-balancing and then each state of a plurality of cells Cell₁ to Cellₙ connected in parallel is the same. That is, the terminal voltage VT₀ value may be the same as both the first voltage V1₀ and the second voltage V2₀ value (VT₀ = V1₀ = V2₀). The BMS 60 may store the terminal voltage VT₀ value measured in the 0th estimation period T₀ in the memory 40 as the first voltage V1₀ value and the second voltage V2₀ value.

Next, the BMS 60 may estimate the first state of charging SOC1₁ and the second state of charging SOC2₁ by applying the first current I1₁ value and the second current I2₁ value to the capacity estimation model. In this case, the first state of charging SOC1₁ and the second state of charging SOC2₁ may correspond to the cell capacities of the first battery cell Cell₁ and the second battery cell Cell₂, respectively.

For example, the capacity estimation model may be an estimation model to which a current integration method is applied, but is not limited thereto. The capacity estimation model may include an estimation model to which various methods of estimating the cell voltage based on the cell current are applied.

Next, the BMS 60, based on the second look-up table in which the SOC-OCV relationship stored in the memory 40 is recorded, estimates the first voltage V1_{N} value and the second voltage V2_{N} value corresponding to each of the first state of charging SOC1₁ and the second state of charging SOC2₁. In this case, the first voltage V1_{N} and the second voltage V2_{N} may correspond to the cell voltages of the first battery cell Cell₁ and the second battery cell Cell₂, respectively.

FIG. 4 is a flowchart explaining a cell voltage estimation method according to another embodiment.

Hereinafter, the cell voltage estimation method and the battery system providing the method are described in detail with reference to FIG. 1 to FIG. 4. Also, In FIG. 3, only three battery modules 1, 2, and 3 are illustrated, but the present disclosure is not limited thereto, and the battery 10 may include more battery modules.

Referring to FIG. 3 and FIG. 4, the BMS 60 measures the terminal voltage V_{T} that is the voltage across both terminals of a plurality of battery modules 1 to 3, respectively (S110).

Hereinafter, the method of estimating the cell voltage of each of a plurality of battery cells Cell₁₁-Cell₁ₙ included in the first battery module 1 is described, but the cell voltage of a plurality of battery cells included in each of the second battery module 2 and the third battery module 3 may be estimated by the same method.

In a 0th estimation period T0, it is assumed that the battery cells are in an initial state in which the battery cells are not used, or a plurality of battery cells Cell₁ to Cellₙ sufficiently perform the self-balancing and then each state of a plurality of cells Cell₁ to Cellₙ connected in parallel is the same. That is, the terminal voltage VT₀ value may be equal to the cell voltage value of each of a plurality of cells Cell₁₁-Cell₁ₙ in the 0th estimation period T₀ (V_{T0} = V1₁₀, ..., = V1ₙ₀).

According to an embodiment, the step (S110) may be a step performed in the 0th estimation period T₀. The BMS 60 may store the measured terminal voltage VT₀ value in the memory 40 as the cell voltage value of each of a plurality of cells Cell₁₁-Cell₁ₙ in the 0th estimation period T₀.

Next, the BMS 60 receives a cell temperature value of each of a plurality of battery cells Cell₁₁-Cell₁ₙ from the temperature sensor 50 (S120).

The temperature sensor 50, for each predetermined estimation period T₁, ..., T_{N-1}, T_{N}, may measure the cell temperature of each of a plurality of battery cells Cell₁₁ to Cell₁ₙ, and transmit the measurement result to the BMS 60. Hereinafter, unless otherwise specified, the steps and values performed in the N-th estimation period may be used. In this case, N is a natural number of greater than or equal to 1.

Next, the BMS 60 estimates a cell resistance value of each of a plurality of cells Cell₁₁ to Cell₁ₙ based on the measured cell temperature value and the first look-up table (S130).

For example, the BMS 60 may find a cell resistance value mapped to the cell temperature value of each of a plurality of cells Cell₁₁ to Cell₁ₙ in the first look-up table, and estimate the cell resistance value of each of a plurality of cells Cell₁₁ to Cell₁ₙ.

Next, the BMS 60 calculates the cell current value of each of a plurality of cells Cell₁₁ to Cell₁ₙ in the current estimation period T_{N} based on the cell voltage value of the previous estimation period T_{N-1} and the cell resistance value of the current estimation period T_{N} (S140).

The current and the voltage are closely related to the passage of time. That is, the current value at the predetermined estimation time (e.g., the N time) is closely related to the voltage value of the previous estimation time N-1. From this point of view, adding the concept of time to Ohm's law may be the same as Equations 1 and 2.

According to an embodiment, the BMS 60 may calculate the cell current value in the current estimation period T_{N} for a plurality of cells Cell₁₁ to Cell₁ₙ, respectively, based on Equations 1 and 2, and the like.

Next, the BMS 60 estimates the cell capacity of each of a plurality of cells Cell₁₁ to Cell₁ₙ by applying the cell current value of each of the plurality of cells Cell₁₁ to Cell₁ₙ to the capacity estimation model (S150).

For example, the capacity estimation model may be an estimation model to which a current integration method is applied, but is not limited thereto. The capacity estimation model may include an estimation model to which various methods of estimating the cell voltage based on the cell current are applied.

Next, the BMS 60 estimates the cell voltage value of each of a plurality of cells Cell₁₁ to Cell₁ₙ based on the estimated cell capacity and the second look-up table (S160).

Referring to FIG. 3, for example, the BMS 60 may estimate the cell voltage value of a plurality of battery cells included in each of a plurality of battery modules 1 to 3, and store the estimated cell voltage value in the memory 40.

Next, the BMS 60 determines the necessity of the module balancing between a plurality of battery modules 1 to 3 connected in series based on the estimated cell voltage value (S170).

According to an embodiment, the BMS 60 determines the minimum cell voltage value among the cell voltage values of a plurality of battery cells included in the predetermined battery module as the module voltage value of the corresponding battery module, and determines the necessity of the module balancing.

For example, it is assumed that the estimated cell voltage values of each of the first to third battery cells included in the first battery module 1 are 4.0 V, 3.6 V, and 4.0 V, and the terminal voltage V_{T} value of the voltage across both terminals of the first battery module 1 is measured as 4.0 V, and conventionally, the voltage value of the first battery module 1 is determined as the measured terminal voltage V_{T} value (4.0 V), and the voltage value of the first battery module 1 has no deviation (or less) for the voltage value of the second battery module 2 and the third battery module 3 (e.g., 4.0 V, respectively), so that it was determined that the module balancing was not necessary. Then, a problem such as accelerated aging of the second battery cell (Cell₁₂) included in the first battery module 1 may occur due to over-discharge/overcharge.

The BMS 60 according to an embodiment, estimates the minimum cell voltage value (e.g., 3.6 V) among the cell voltage values of the first to third battery cells Cell₁₁-Cell₁₃ included in the first battery module 1 as the voltage value of the first battery module 1, and compares the voltage value of the first battery module 1 (e.g., 3.6 V) with the voltage value of the second battery module 2 and the third battery module 3 (e.g., 4.0 V, respectively), thereby determining that the module balancing is necessary.

Next, if the module balancing is required (S170, Yes), the BMS 60 performs the module balancing (S180).

The BMS 60 may perform the module balancing by using various conventionally known balancing methods.

Next, if the module balancing is not required (S170, No) or the module balancing is terminated, the BMS 60 counts the next estimation period T_{N+1}, and when the next estimation period T_{N+1} arrives, the process is repeated from the step S120 (S190).

While this disclosure has been described in connection with what is presently considered to be practical embodiments, it is to be understood that the disclosure is not limited to the disclosed embodiments.

## Claims

1. A battery system (1) comprising:
a battery (10) including a plurality of battery modules connected in series, each of the plurality of battery modules comprising a plurality of battery cells (Cellₙ) connected in parallel;
a temperature sensor (50) measuring a cell temperature of each of the plurality of battery cells (Cellₙ); and
a battery management system, BMS (60),
wherein the BMS (60) determines an estimated cell resistance value (Rⱼ) corresponding to a measured cell temperature value (Cⱼ) by using a first look-up table for each of the plurality of battery cells (Cellₙ),
wherein the BMS (60) determines an estimated cell current value (Iⱼ) based on the estimated cell resistance value (Rⱼ) and an estimated cell voltage value (Vⱼ) estimated during a (N-1)-th estimation period, N being a natural number greater than or equal to 1,
wherein the BMS (60) determines an estimated cell capacity (SOCⱼ) corresponding to the estimated cell current value (Iⱼ) by using a capacity estimation model, and
wherein the BMS (60) determines the estimated cell voltage value (Vⱼ) corresponding to the estimated cell capacity (SOCⱼ) as the estimated cell voltage value (Vⱼ) during an N-th estimation period using a second look-up table, wherein
the BMS (60) determines whether to perform a module balancing between each of the plurality of battery modules connected in series based on the estimated cell voltage value (Vⱼ) for each of the plurality of battery cells (Cellₙ), and
the BMS (60) determines a module voltage value (V_{T}) of each of the plurality of battery modules based on a minimum cell voltage value (Vⱼ) among a plurality of cell voltage values (Vⱼ) of the plurality of battery cells (Cellₙ) included in each of the plurality of battery modules, and
wherein the BMS (60) determines whether to perform the module balancing based on the module voltage value (V_{T}).

2. The battery system (1) of claim 1, wherein the first look-up table includes the estimated cell resistance value (Rⱼ) corresponding to a predetermined cell temperature value (Cⱼ),
wherein the capacity estimation model determines the estimated cell capacity (SOCⱼ) corresponding to a predetermined cell current value (Iⱼ), and
wherein the second look-up table includes a cell voltage value (Vⱼ) corresponding to a predetermined cell capacity (SOCⱼ).

3. The battery system (1) of claim 1, wherein the first look-up table includes a cell resistance value (Rⱼ) corresponding to a predetermined cell temperature value (Cⱼ),
wherein the capacity estimation model determines the estimated cell capacity (SOCⱼ) corresponding to a predetermined cell current value (Iⱼ), and
wherein the second look-up table includes a cell voltage value (Vⱼ) corresponding to a predetermined cell capacity (SOCⱼ).

4. A method for determining an estimated cell voltage value (Vⱼ) for each of a plurality of battery cells (Cellₙ) in a battery system (1), the battery system (1) including a plurality of battery modules connected in series and the plurality of battery cells (Cellₙ) connected in parallel in each of the plurality of battery modules,
wherein the method comprises:
receiving (S120) a measured cell temperature value (Cⱼ) of each of the plurality of battery cells (Cellₙ);
determining (S130) an estimated cell resistance value (Rⱼ) corresponding to the measured cell temperature value (Cⱼ) by using a first look-up table;
determining (S140) an estimated cell current value (Iⱼ) based on the estimated cell resistance value (Rⱼ) and an estimated cell voltage value (Vⱼ) during an (N-1)-th estimation period, N being a natural number greater than or equal to 1;
determining (S150) an estimated cell capacity (SOCⱼ) corresponding to the estimated cell current value (Iⱼ) by using a capacity estimation model; and
determining (S160) the estimated cell voltage value (Vⱼ) corresponding to the estimated cell capacity (SOCⱼ) as the estimated cell voltage value (Vⱼ) using a second look-up table during an N-th estimation period, further comprising, after determining the estimated cell voltage value (Vⱼ), determining (S170) whether to perform a module balancing between the plurality of battery modules based on the estimated cell voltage value (Vⱼ) for each of the plurality of battery cells (Cellₙ), wherein whether to perform the module balancing is determined (S170) based on a minimum cell voltage value (Vⱼ),
wherein a module voltage value (V_{T}) of each of the plurality of battery modules is determined based on a minimum cell voltage value (Vⱼ) among a plurality of cell voltage values (Vⱼ) of the plurality of battery cells (Cellₙ) included in each of the plurality of battery modules, and
wherein whether to perform the module balancing is determined (S170) based on the module voltage value (V_{T}).

5. The method of claim 4, further comprising, upon determining (S170) performing of the module balancing is required,
performing (S180) the module balancing based on a lowest module voltage value (VT) among module voltage values (VT) of the plurality of battery modules.

6. The method of claim 4, wherein the first look-up table includes a cell resistance value (Rj) corresponding to a predetermined cell temperature value (Cj),
wherein the capacity estimation model determines the estimated cell capacity (SOCj) corresponding to a predetermined cell current value (Ij), and
the second look-up table includes a cell voltage value (Vj) corresponding to the predetermined cell capacity (SOCj).

7. The battery system (1) of claim 1, wherein the estimated cell capacity (SOCⱼ) corresponds to a State of Charge ,SOC.

8. The battery system (1) of claim 2, wherein the cell voltage value (Vⱼ) corresponds to an Open Circuit Voltage ,OCV.

9. The battery system (1) of claim 1, wherein the estimated cell capacity (SOCⱼ) corresponds to a State of Charge ,SOC.

10. The battery system (1) of claim 3, wherein the cell voltage value (Vⱼ) corresponds to an Open Circuit Voltage ,OCV.

11. The method of claim 4, wherein the estimated cell capacity (SOCⱼ) corresponds to a State of Charge ,SOC.

12. The method of claim 5, wherein the cell voltage value (Vⱼ) corresponds to an Open Circuit Voltage (OCV).

## Patentansprüche

1. Batteriesystem (1), umfassend:
eine Batterie (10), die eine Vielzahl in Reihe geschalteter Batteriemodule aufweist, wobei jedes der Vielzahl von Batteriemodulen eine Vielzahl parallel geschalteter Batteriezellen (Cellₙ) umfasst;
einen Temperatursensor (50), der eine Zelltemperatur jeder der Vielzahl von Batteriezellen (Cellₙ) misst; und
ein Batteriemanagementsystem, BMS (60),
wobei das BMS (60) einen geschätzten Zellwiderstandswert (Rⱼ), der zu einem gemessenen Zelltemperaturwert (Cⱼ) korrespondiert, unter Verwendung einer ersten Nachschlagetabelle für jede der Vielzahl von Batteriezellen (Cellₙ) bestimmt,
wobei das BMS (60) einen geschätzten Zellstromwert (Iⱼ) basierend auf dem geschätzten Zellwiderstandswert (Rⱼ) und einem geschätzten Zellspannungswert (Vⱼ) bestimmt, der während einer (N-1)-ten Schätzperiode geschätzt wird, wobei N eine natürliche Zahl größer oder gleich 1 ist,
wobei das BMS (60) eine geschätzte Zellkapazität (SOCⱼ), die zu dem geschätzten Zellstromwert (Iⱼ) korrespondiert, unter Verwendung eines Kapazitätsschätzmodells bestimmt, und
wobei das BMS (60) den geschätzten Zellspannungswert (Vⱼ), der der geschätzten Zellkapazität (SOCⱼ) entspricht, als den geschätzten Zellspannungswert (Vⱼ) während einer N-ten Schätzperiode unter Verwendung einer zweiten Nachschlagetabelle bestimmt, wobei
das BMS (60) bestimmt, ob ein Modulausgleich zwischen jedem der Vielzahl in Reihe geschalteter Batteriemodule basierend auf dem geschätzten Zellspannungswert (Vⱼ) für jede der Vielzahl von Batteriezellen (Cellₙ) durchgeführt werden soll, und
das BMS (60) einen Modulspannungswert (V_{T}) jedes der Vielzahl von Batteriemodulen basierend auf einem minimalen Zellspannungswert (Vⱼ) unter einer Vielzahl von Zellspannungswerten (Vⱼ) der Vielzahl von Batteriezellen (Cellₙ) bestimmt, den jede der Vielzahl von Batteriemodulen aufweist, und
wobei das BMS (60) bestimmt, ob der Modulausgleich basierend auf dem Modulspannungswert (V_{T}) durchgeführt werden soll.

2. Batteriesystem (1) nach Anspruch 1, wobei die erste Nachschlagetabelle den geschätzten Zellwiderstandswert (Rⱼ) aufweist, der einem vorbestimmten Zelltemperaturwert (Cⱼ) entspricht,
wobei das Kapazitätsschätzmodell die geschätzte Zellkapazität (SOCⱼ) einem vorbestimmten Zellstromwert (Iⱼ) entsprechend bestimmt, und
wobei die zweite Nachschlagetabelle einen Zellspannungswert (Vⱼ) aufweist, der mit einer vorbestimmten Zellkapazität (SOCⱼ) korrespondiert.

3. Batteriesystem (1) nach Anspruch 1, wobei die erste Nachschlagetabelle einen Zellwiderstandswert (Rⱼ) aufweist, der zu einem vorbestimmten Zelltemperaturwert (Cⱼ) korrespondiert,
wobei das Kapazitätsschätzmodell die geschätzte Zellkapazität (SOCⱼ) einem vorbestimmten Zellstromwert (Iⱼ) korrespondierend bestimmt, und
wobei die zweite Nachschlagetabelle einen Zellspannungswert (Vⱼ) aufweist, der zu einer vorbestimmten Zellkapazität (SOCⱼ) korrespondiert.

4. Verfahren zum Bestimmen eines geschätzten Zellspannungswerts (Vⱼ) für jede einer Vielzahl von Batteriezellen (Cellₙ) in einem Batteriesystem (1), wobei das Batteriesystem (1) eine Vielzahl in Reihe geschalteter Batteriemodule und die Vielzahl parallel geschalteter Batteriezellen (Cellₙ) in jedem der Vielzahl von Batteriemodulen aufweist,
wobei das Verfahren umfasst:
Empfangen (S120) eines gemessenen Zelltemperaturwerts (Cⱼ) jeder der Vielzahl von Batteriezellen (Cellₙ);
Bestimmen (S130) eines geschätzten Zellwiderstandswerts (Rⱼ), der mit dem gemessenen Zelltemperaturwert (Cⱼ) korrespondiert, unter Verwendung einer ersten Nachschlagetabelle;
Bestimmen (S140) eines geschätzten Zellstromwerts (Iⱼ) basierend auf dem geschätzten Zellwiderstandswert (Rⱼ) und einem geschätzten Zellspannungswert (Vⱼ) während einer (N-1)-ten Schätzperiode, wobei N eine natürliche Zahl größer oder gleich 1 ist;
Bestimmen (S150) einer geschätzten Zellkapazität (SOCⱼ), die zu dem geschätzten Zellstromwert (Iⱼ) korrespondiert, unter Verwendung eines Kapazitätsschätzmodells; und
Bestimmen (S160) des geschätzten Zellspannungswerts (Vⱼ), korresppndierend zu der geschätzten Zellkapazität (SOCⱼ), als den geschätzten Zellspannungswert (Vⱼ) unter Verwendung einer zweiten Nachschlagetabelle während einer N-ten Schätzperiode, ferner umfassend, nach dem Bestimmen des geschätzten Zellspannungswerts (Vⱼ), Bestimmen (S170), ob ein Modulausgleich zwischen der Vielzahl von Batteriemodulen basierend auf dem geschätzten Zellspannungswert (Vⱼ) für jede der Vielzahl von Batteriezellen (Cellₙ) durchgeführt wird, wobei basierend auf einem minimalen Zellspannungswert (Vⱼ) bestimmt wird (S170), ob der Modulausgleich durchgeführt wird,
wobei ein Modulspannungswert (V_{T}) jedes der Vielzahl von Batteriemodulen basierend auf einem minimalen Zellspannungswert (Vⱼ) unter einer Vielzahl von Zellspannungswerten (Vⱼ) der Vielzahl von Batteriezellen (Cellₙ) bestimmt wird, den jede der Vielzahl von Batteriemodulen aufweist, und
wobei basierend auf dem Modulspannungswert (V_{T}) bestimmt wird (S170), ob der Modulausgleich durchgeführt werden soll.

5. Verfahren nach Anspruch 4, ferner umfassend, dass nach dem Bestimmen (S170) das Durchführen des Modulausgleichs erforderlich ist,
Durchführen (S180) des Modulausgleichs basierend auf einem niedrigsten Modulspannungswert (VT) von den Modulspannungswerten (VT) der Vielzahl von Batteriemodulen.

6. Verfahren nach Anspruch 4, wobei die erste Nachschlagetabelle einen Zellwiderstandswert (Rj) aufweist, der mit einem vorbestimmten Zelltemperaturwert (Cj) korrespondiert,
wobei das Kapazitätsschätzmodell die geschätzte Zellkapazität (SOCj) korrespondierend zu einem vorbestimmten Zellstromwert (Ij) bestimmt, und
die zweite Nachschlagetabelle einen Zellspannungswert (Vj) aufweist, der zu der vorbestimmten Zellkapazität (SOCj) korrespondiert.

7. Batteriesystem (1) nach Anspruch 1, wobei die geschätzte Zellkapazität (SOCⱼ) einem Ladezustand, SOC, entspricht.

8. Batteriesystem (1) nach Anspruch 2, wobei der Zellspannungswert (Vⱼ) zu einer Leerlaufspannung, OCV, korrespondiert.

9. Batteriesystem (1) nach Anspruch 1, wobei die geschätzte Zellkapazität (SOCⱼ) zu einem Ladezustand, SOC, korrespondiert.

10. Batteriesystem (1) nach Anspruch 3, wobei der Zellspannungswert (Vⱼ) zu einer Leerlaufspannung, OCV, korrespondiert.

11. Verfahren nach Anspruch 4, wobei die geschätzte Zellkapazität (SOCⱼ) zu einem Ladezustand, SOC, korrespondiert.

12. Verfahren nach Anspruch 5, wobei der Zellspannungswert (Vⱼ) zu einer Leerlaufspannung (OCV) korrespondiert.

## Revendications

1. Système de batterie (1) comprenant :
une batterie (10) possédant une pluralité de modules de batterie connectés en série, chacun de la pluralité de modules de batterie comprenant une pluralité d'éléments de batterie (Cellₙ) connectés en parallèle ;
un capteur de température (50) mesurant une température d'élément de chacun de la pluralité d'éléments de batterie (Cellₙ) ; et
un système de gestion de batterie, BMS, (60),
le BMS (60) déterminant une valeur estimée de la résistance de l'élément (Rⱼ) correspondant à une valeur de la température mesurée de l'élément (Cⱼ) en utilisant une première table de consultation pour chacun de la pluralité d'éléments de batterie (Cellₙ),
le BMS (60) déterminant une valeur estimée du courant de l'élément (Iⱼ) basée sur la valeur estimée de la résistance (Rⱼ) de l'élément, et une valeur estimée de la tension de l'élément (Vⱼ), estimée au cours d'une (N-1)^{ème} période d'estimation, N étant un entier naturel supérieur ou égal à 1,
le BMS (60) déterminant une capacité estimée de l'élément (SOCⱼ) correspondant à la valeur estimé du courant de l'élément (Iⱼ) en utilisant un modèle d'estimation de la capacité, et
le BMS (60) déterminant la valeur estimée de la tension de l'élément (Vⱼ) correspondant à la capacité estimée de l'élément (SOCⱼ) en tant que valeur estimée de la tension de l'élément (Vⱼ) au cours d'une N^{ème} période d'estimation en utilisant une deuxième table de consultation,
le BMS (60) déterminant s'il s'agit d'effectuer un équilibrage du module entre chacun de la pluralité de modules de batterie connectés en série d'après la valeur estimée de la tension de l'élément (Vⱼ) pour chacun de la pluralité d'éléments de batterie (Cellₙ), et
le BMS (60) déterminant une valeur de tension du module (V_{T}) pour chacun de la pluralité de modules de batterie d'après une valeur de tension minimum de l'élément (Vⱼ) parmi une pluralité de valeurs de tension de l'élément (Vⱼ) de la pluralité d'éléments de batterie (Cellₙ) compris dans chacun de la pluralité de modules de batterie,
le BMS (60) déterminant la nécessité éventuelle d'effectuer l'équilibrage des modules d'après la valeur de tension de module (V_{T}).

2. Système de batterie (1) selon la revendication 1, la première table de consultation comprenant la valeur estimée de résistance de l'élément (Rⱼ) correspondant à une valeur prédéterminée de la température de l'élément (Cⱼ),
le modèle d'estimation de la capacité déterminant la capacité estimée de l'élément (SOCⱼ) correspondant à une valeur prédéterminée du courant de l'élément (Iⱼ), et
la deuxième table de consultation comprenant une valeur de tension de l'élément (Vⱼ) correspondant à une capacité prédéterminée de l'élément (SOCⱼ).

3. Système de batterie (1) selon la revendication 1, la première table de consultation comprenant une valeur de résistance de l'élément (Rⱼ) correspondant à une valeur prédéterminée de la température de l'élément (Cⱼ),
le modèle d'estimation de la capacité déterminant la capacité estimée de l'élément (SOCⱼ) correspondant à une valeur prédéterminée du courant de l'élément (Iⱼ), et
la deuxième table de consultation comprenant une valeur de tension de l'élément (Vⱼ) correspondant à une capacité prédéterminée de l'élément (SOCⱼ).

4. Procédé de détermination d'une valeur estimée de tension de l'élément (Vⱼ) pour chacun d'une pluralité d'éléments de batterie (Cellₙ) dans un système de batterie (1), le système de batterie (1) comprenant une pluralité de modules de batterie connectés en série, et la pluralité de modules de batterie (Cellₙ) connectés en parallèle dans chacun de la pluralité de modules de batterie,
le procédé comprenant :
la réception (S120) d'une valeur mesurée de la température de l'élément (Cⱼ) pour chacun de la pluralité d'éléments de batterie (Cellₙ) ;
la détermination (S130) d'une valeur estimée de résistance de l'élément (Rⱼ) correspondant à la valeur mesurée de la température de l'élément (Cⱼ) en utilisant une première table de consultation ;
la détermination (S140) d'une valeur estimée du courant de l'élément (Iⱼ) d'après la valeur estimée de la résistance de l'élément (Rⱼ) et d'une valeur estimée de la tension de l'élément (Vⱼ) au cours d'une (N-1)^{ème} période d'estimation, N étant un entier naturel supérieur ou égal à 1 ;
la détermination (S150) d'une capacité estimée de l'élément (SOCⱼ) correspondant à la valeur estimée du courant de l'élément (Iⱼ) en utilisant un modèle d'estimation de la capacité ; et
la détermination (S160) d'une valeur estimée de tension de l'élément (Vⱼ) correspondant à la capacité estimée de l'élément (SOCⱼ) en tant que valeur estimée de la tension de l'élément (Vⱼ), en utilisant une deuxième table de consultation au cours d'une N^{ème} période d'estimation, comprenant en outre, après la détermination de la valeur estimée de la tension de l'élément (Vⱼ), la détermination (S170) de la nécessité éventuelle d'effectuer un équilibrage des modules entre la pluralité de modules de batterie d'après la valeur estimée de la tension de l'élément (Vⱼ) pour chacun de la pluralité d'éléments de batterie (Cellₙ), la nécessité éventuelle de l'exécution de l'équilibrage des modules étant déterminée (S170) en fonction d'une valeur de la tension minimum de l'élément (Vⱼ)
une valeur de tension du module (V_{T}) pour chacun de la pluralité de modules de batterie étant déterminée d'après une valeur minimum de tension d'élément (Vⱼ) parmi une pluralité de valeurs de tension d'élément (Vⱼ) de la pluralité d'éléments de batterie (Cellₙ) compris dans chacun de la pluralité de modules de batterie,
et
la nécessité éventuelle de l'exécution de l'équilibrage de modules étant déterminée (S170) d'après la valeur de la tension des modules (V_{T}).

5. Procédé selon la revendication 4, comprenant en outre, lors de la détermination (S170) de la nécessité éventuelle d'un équilibrage de modules,
l'exécution (S180) de l'équilibrage de modules d'après la valeur la plus basse de la tension de module (VT) parmi les valeurs de tension de module (VT) de la pluralité de modules de batterie.

6. Procédé selon la revendication 4, la première table de consultation comprenant une valeur de résistance de l'élément (Rⱼ) correspondant à une valeur prédéterminée de la température de l'élément (Cⱼ),
le modèle d'estimation de la capacité déterminant la capacité estimée de l'élément (SOCⱼ) correspondant à une valeur prédéterminée du courant de l'élément (Iⱼ), et
la deuxième table de consultation comprenant une valeur de tension d'élément (Vⱼ) correspondant à la capacité prédéterminée de l'élément (SOCⱼ).

7. Système de batterie (1) selon la revendication 1, la capacité estimée de l'élément (SOCⱼ) correspondant à un état de la charge (SOC).

8. Système de batterie (1) selon la revendication 2, la valeur de tension de l'élément (Vⱼ) correspondant à une tension de circuit ouvert, OCV.

9. Système de batterie (1) selon la revendication 1, la capacité estimée de l'élément (SOCⱼ) correspondant à un état de la charge (SOC).

10. Système de batterie (1) selon la revendication 3, la valeur de tension de l'élément (Vⱼ) correspondant à une tension de circuit ouvert, OCV.

11. Procédé selon la revendication 4, la capacité estimée de l'élément (SOCⱼ) correspondant à un état de la charge (SOC).

12. Procédé selon la revendication 5, la valeur de tension de l'élément (Vⱼ) correspondant à une tension de circuit ouvert, OCV.
